# EUROPÄISCHE PATENTSCHRIFT

(11) **EP 1 047 575 B1**
(45) Veröffentlichungstag und Bekanntmachung des Hinweises auf die Patenterteilung: **11.01.2006**
(21) Anmeldenummer: 99955977.6
(22) Anmeldetag: 11.11.1999
(51) Int. Cl.: B60Q 11/00

(54) **DIAGNOSESYSTEM FÜR DAS VORSCHALTGERÄT EINER HOCHDRUCKGASENTLADUNGSLAMPE IN EINEM KRAFTFAHRZEUG**
DIAGNOSTIC SYSTEM FOR THE WATTAGE POWER REGULATOR OF A HIGH-PRESSURE GAS-DISCHARGE LAMP IN A VEHICLE
SYSTEME DIAGNOSTIQUE POUR LE REGULATEUR DE PUISSANCE DE WATTAGE D'UNE LAMPE A DECHARGE GAZEUSE HAUTE PRESSION DANS UNE AUTOMOBILE

(30) Priorität: 13.11.1998 DE 19852350
(43) Veröffentlichungstag der Anmeldung: 02.11.2000
(73) Patentinhaber: Hella KGaA Hueck & Co., 59552 Lippstadt (DE)
(72) Erfinder: DAUB, Wolfgang, D-59609 Anröchte (DE); RADTKE, Volker, D-33330 Gütersloh (DE)
(86) Internationale Anmeldenummer: PCT/EP1999/008682
(87) Internationale Veröffentlichungsnummer: WO 2000/029255

(56) Entgegenhaltungen:
- WO-A-92/00579
- DE-C- 4 341 058
- US-A- 5 151 631

## Beschreibung

Die Erfindung betrifft ein Diagnosesystem für das Vorschaltgerät einer Hochdruckgasentladungslampe in einem Kraftfahrzeug mit einem Lichtsteuermodul, welches das Vorschaltgerät an eine Betriebsspannungsquelle anschaltet und die Stromaufnahme des Vorschaltgerätes überwacht, und mit einem Vorschaltgerät, welches aufweist: einen Spannungswandler zur Spannungsversorgung der Hochdruckgasentladungslampe, eine Sicherheitsschaltung zur Erkennung von Fehlfunktionen des Vorschaltgerätes und der Hochdruckgasentladungslampe, welche im Fehlerfall den Spannungswandler abschaltet, und eine Diagnoseschaltung, die im Fehlerfall ein Fehlersignal erzeugt.

Beleuchtungseinrichtungen werden in immer mehr Fahrzeugen über ein Lichtsteuermodul geschaltet. Eine Lichtsteuereinrichtung für ein Kraftfahrzeug zeigt die DE 43 41 058 C1 (Oberbegriff von Anspruch 1), wobei dieses Beispiel zeigt, daß eine solche Einrichtung sehr komplex ausgeführt sein kann. So ist hier sowohl das Lichtsteuermodul als auch das Leuchtenmodul als "intelligente", d. h. mit einem Mikrorechner versehene, Baugruppe ausgeführt, wodurch eine solche Lichtsteuereinrichtung recht kostenaufwendig ist. Gerade in der Kraftfahrzeugtechnik werden aber aus Kostengründen besonders einfach ausgestaltete Ausführungen von Lichtsteuereinrichtungen bevorzugt.

Zumeist weist ein Lichtsteuermodul eine Einrichtung zur Stromkontrolle auf, die z. B. bei angesteuerten Glühlampen dem Fahrer anzeigt, ob eine Glühlampe gewechselt werden muß. Problematisch ist dies bei der Ansteuerung der zunehmend in Kraftfahrzeugen verwendeten Hochdruckgasentladungslampen, da diese mittels eines Vorschaltgerätes betrieben werden. Bei Hochdruckgasentladungslampen kann das Lichtsteuermodul nämlich nicht unterscheiden, ob die Lampe oder das zugehörige Vorschaltgerät defekt ist. Daher ist es von Vorteil, wenn das Vorschaltgerät die Diagnose übernimmt und die Daten dem Lichtsteuermodul übermittelt.

Handelsübliche Vorschaltgeräte für Hochdruckgasentladungslampen, z. B. solche der Anmelderin, besitzen hierzu einen Diagnoseausgang, der über eine Diagnoseleitung mit dem Lichtsteuermodul verbunden ist. Der Verkabelungsaufwand für eine zusätzliche Diagnoseleitung je Vorschaltgerät verursacht dabei Mehrkosten; dies gilt ebenso für Bauteile zur Ausgabe der Diagnosesignale (Ausgangstreiber, evtl. sogar ein Mikroprozessor) innerhalb des Vorschaltgerätes, wobei diese Mehrkosten sogar dann anfallen, wenn in einem Fahrzeug die Diagnosemöglichkeit gar nicht genutzt werden soll.

Es ist daher die Aufgabe der Erfindung, ein Diagnosesystem für das Vorschaltgerät einer Hochdruckgasentladungslampe in einem Kraftfahrzeug zu schaffen, welches besonders einfach und kostengünstig im Aufbau ist.

Diese Aufgabe wird erfindungsgemäß dadurch gelöst, daß im Fehlerfall die Diagnoseschaltung die Stromaufnahme des Vorschaltgerätes mittels einer schaltbaren Stromsenke in Abhängigkeit von der Art des aufgetretenen Fehlers moduliert und daß das Lichtsteuermodul den modulierten Strom in ein Spannungssignal wandelt und aus dem Spannungssignal die Art des aufgetretenen Fehlers erkennt.

Die erfindungsgemäße Diagnoseeinrichtung benötigt somit vorteilhafterweise keine eigene Diagnoseleitung, da die Diagnoseinformation durch eine Ruhestrommodulation auf der Versorgungsleitung des Vorschaltgerätes erfolgt.

Überdies ist der Aufwand an Bauteilen zur Erzeugung, Übermittlung und Auswertung der Diagnoseinformation im Vorschaltgerät und im Lichtsteuermodul äußerst gering. So werden keine speziellen Aus- und Eingänge für die Diagnoseinformation mehr benötigt.

Weitere vorteilhafte Ausgestaltungen und Weiterbildungen des erfindungsgemäßen Diagnosesystems gehen aus den Unteransprüchen hervor.

So kann der modulierte Ruhestrom vorteilhaft über einen in die Versorgungsleitung geschalteten Widerstand oder über den Ausgangswiderstand einer Stromspiegelschaltung in ein Spannungssignal gewandelt werden, welches durch einen Eingang der Schalt- und Auswertelogik erfaßt und durch die Schalt-und Auswertelogik hinsichtlich der Art des aufgetretenen Fehlers ausgewertet wird.

Die Modulation des Ruhestromes kann vorteilhafterweise eine Pulsweitenmodulation mit niedriger Frequenz sein, da diese durch einen hochfrequente Störimpulse des Vorschaltgerätes eliminierenden Filter (EMC-FÜter) nicht beeinflußt wird.

Besonders vorteilhaft ist es, wenn das Diagnosesignal eine Rechteckfrequenz mit definierter Pulsweite ist. Durch Zuordnen einer bestimmten Frequenz zu jedem möglichen Fehler läßt sich eine einfache Codierung der Fehler erreichen. Hierbei läßt sich sowohl aus der Frequenz als auch aus dem Mittelwert der Signalspannung das Diagnosedatum decodieren.

Ebenfalls von besonderem Vorteil ist, daß sich eine solche fehlerabhängige Modulation auch in einem Vorschaltgerät "ohne Intelligenz", also ohne eigenen Mikrorechner, realisieren läßt, wodurch das Vorschaltgerät besonders kostengünstig ausführbar ist. Lediglich für die Schalt- und Auswertelogik des Lichtsteuermoduls ist ein Mikrorechner vorzusehen.

Weiterhin ist es vorteilhaft, dem Fahrer aufgetretene Fehler in einem Anzeigeelement anzuzeigen und darüber hinaus diese auch noch für spätere Fehleranalysen in einem nichtflüchtigen Speicher (EEPROM) zu sichern.

Im folgenden soll ein Ausführungsbeispiel einer erfindungsgemäßen Diagnoseeinrichtung anhand der Zeichnung dargestellt und näher erläutert werden.

Es zeigen
- Figur 1: eine Prinzipskizze der erfindungsgemäßen Diagnoseeinrichtung;
- Figur 2: einige Schaltungsdetails einer erfindungsgemäßen Diagnoseeinrichtung.

Beide Figuren sind in ihrer Darstellung stark vereinfacht und zeigen nur die zur Erläuterung der Erfindung wesentlichen Komponenten.

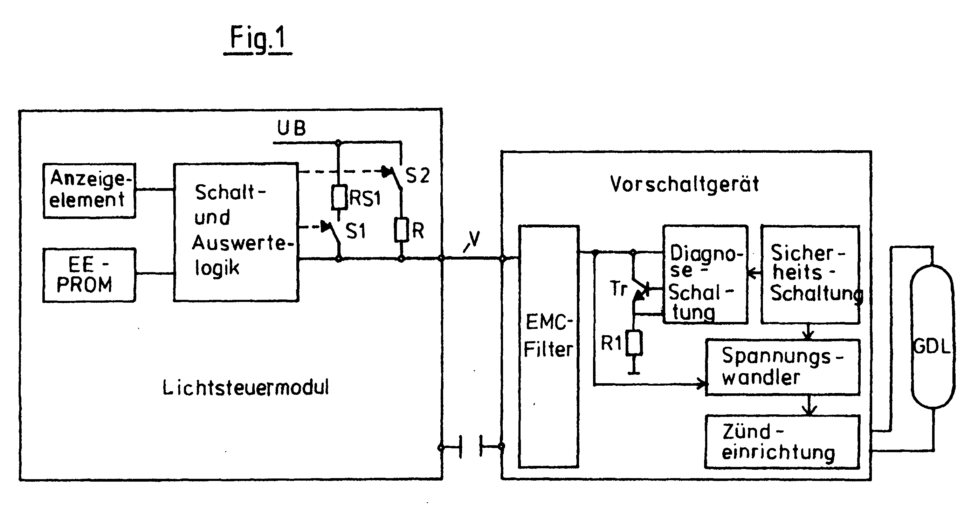

Die Figur 1 zeigt ein Vorschaltgerät für eine Hochdruckgasentladungslampe (GDL). Das Vorschaltgerät weist eine Sicherheitsschaltung auf, die Fehler des Vorschaltgerätes oder der Hochdruckgasentladungslampe (GDL) erkennt oder von anderen, internen Komponenten des Vorschaltgerätes Signale bezüglich erkannter Fehler zugeführt erhält und die im Falle eines Fehlers den Spannungswandler abschaltet, weicher die Hochdruckgasentladungslampe (GDL) mit der erforderlichen Betriebsspannung versorgt. Zwischen dem Spannungswandler und der Hochdruckgasentladungslampe ist zudem eine Zündeinrichtung geschaltet, welche die zum Starten der Gasentladung erforderlichen Hochspannungszündimpulse erzeugt.

Mit der Sicherheitsschaltung ist eine Diagnoseschaltung verbunden, die im Fehlerfall die Art des aufgetretenen Fehlers auf erfindungsgemäße Weise dem Lichtsteuermodul signalisiert.

Das Lichtsteuermodul ist mittels einer Versorgungsleitung (V) mit dem Vorschaltgerät verbunden und schaltet die Versorgungsleitung über einen steuerbaren Schalter (S₁) und einen sehr niederohmigen Widerstand (R_{S1}) an die Betriebsspannungsquelle (UB) für das Vorschaltgerät an. Durch Auswertung des Spannungsabfalls am Widerstand (R_{S1}) kann die Schalt- und Auswertelogik eine Unterbrechung oder einen Masseschluß der Versorgungsleitung (V) erkennen; weitergehende Diagnosemöglichkeiten bezüglich interner Fehler des Vorschaltgerätes sind damit aber nicht möglich.

Solche internen Fehler können insbesondere sein:
- Betriebsspannung zu niedrig
- maximale Zündzeit überschritten, ohne daß ein Zündimpuls gezählt wurde
- maximale Zündzeit bei mindestens einem Zündimpuls überschritten
- maximale Zahl der Zündimpulse überschritten
- Kurzschluß im Lampenkreis
- lampenkreisseitiger Kurzschluß gegen Fahrzeugmasse.

Der Erfindungsgedanke ist nun, in Abhängigkeit von der Art des Fehlers, welcher zum internen Abschalten des Vorschaltgerätes geführt hat, die Ruhestromaufnahme zu modulieren, so daß das Lichtsteuermodul den Fehler auswerten und z. B. in einem nichtflüchtigen Speicher (EEPROM) speichern und auf einem Anzeigeelement dem Fahrer anzeigen kann. Der Diagnosebetriebszustand wird mit einem Fehlersignal aktiviert, welches entsteht, wenn das Vorschaltgerät mit der Betriebsspannung versorgt wird und die Lampe verlischt. Es dient auch zum Anhalten des Spannungswandlers.

Die Modulation des Ruhestroms im Fehlerfall wird durch eine geschaltete Stromsenke (Tr, R₁) realisiert. Dieser modulierte Ruhestrom läßt sich im Lichtsteuergerät, z. B. an einem Pull-up-Widerstand (R) oder an einer Stromquelle oder über einen Stromspiegel (Tr_{SQ1}, Tr_{SQ2}) in ein auswertbares Spannungssignal umwandeln. Bei der Wahl des Modulationsverfahrens muß dabei die dämpfende Wirkung der Eingangskapazität des Vorschaltgerätes sowie des EMC-Filters, welcher hochfrequente Störsignale von der Versorgungsleitung (V) fernhält, berücksichtigt werden. Daher ist eine niederfrequente Pulsweitenmodulation zur Übertragung des Diagnosesignales besonders vorteilhaft.

Im folgenden sei die Funktionsweise des erfindungsgemäßen Diagnosesystems anhand der Figur 1 erläutert:

Das Vorschaltgerät ist mit dem Lichtsteuermodul über die Versorgungsleitung (V) verbunden und wird von diesem über den steuerbaren Schalter (S₁) eigeschaltet. Im Fehlerfall, wenn die Hochdruckgasentladungslampe (GDL) erloschen ist und der Spannungswandler des Vorschaltgerätes angehalten wurde, wird die Diagnoseschaliurtg aktiviert. Das Lichtsteuergerät hat zu diesem Zeitpunkt erkannt, daß der Betriebsstrom des Vorschaltgerätes unter einen vorgegebenen Wert gefallen ist, schließt den steuerbaren Schalter (S₂) und öffnet dann den Schalter (S₁), um das Diagnosesignal zu empfangen, auszuwerten und den Fehler in einem nichtflüchtigen Speicher (EEPROM) speichern und auf dem Anzeigeelement darstellen zu können.

Durch den Transistor (Tr) und den Widerstand (R₁) wird eine schaltbare Stromsenke gebildet, wobei der Spannungsabfall am Widerstand (R₁) bei eingeschaltetem Transistor (Tr) konstant gehalten wird und damit der Strom durch den Transistor (Tr) definiert wird.

Der Pull-up-Widerstand (R) im Lichtsteuermodul ist so ausgelegt, daß die Betriebsspannung am Vorschaltgerät nicht unter ein notwendiges Minimum (z. B. 6 Volt) sinkt.

Die Diagnoseschaltung des Vorschaltgerätes moduliert nun, in Abhängigkeit von der Art des aufgetretenen Fehlers, die Ruhestromaufnahme des Vorschaltgerätes in Form eines pulsweitenmodulierten Signales auf der Versorgungsleitung (V). Durch Zuordnen einer bestimmten Frequenz zu jedem möglichen Fehler läßt sich eine einfache Codierung der Fehler erreichen, wobei es von besonderem Vorteil ist, wenn das Diagnosesignal eine Rechteckfrequenz mit definierter Pulsweite ist. In diesem Fall kann die Schalt- und Auswertelogik sowohl aus der Frequenz als auch aus dem Mittelwert der Signalspannung das Diagnosedatum decodieren.

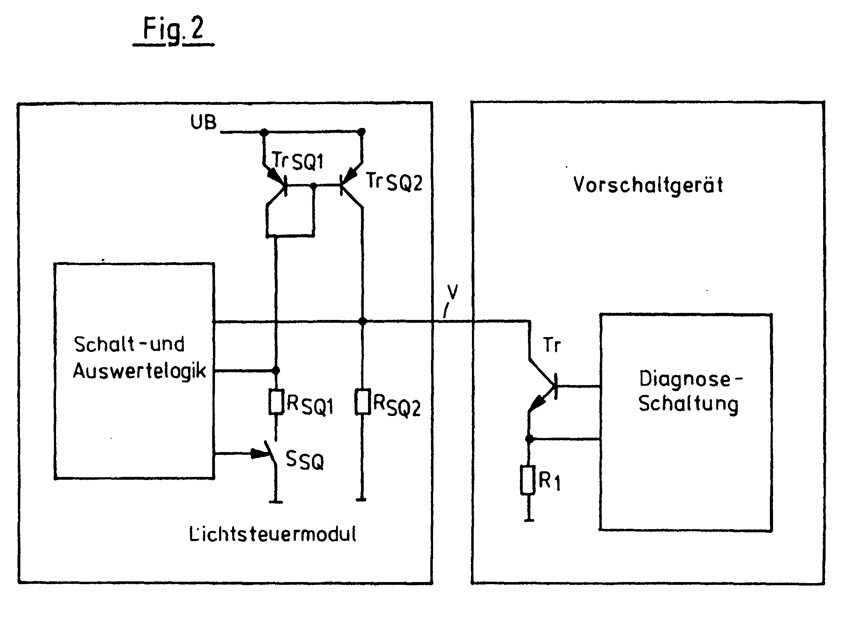

Die Figur 2 zeigt in weiter vereinfachter Darstellung Komponenten des Vorschaltgerätes und des Lichtsteuermoduls. Anhand dieser Schaltung soll eine mögliche Art der Umwandlung des modulierten Ruhestromsignales in ein auswertbares Spannungssignal, und zwar mittels einer sogenannten Stromspiegelschaltung, erläutert werden.

Das Lichtsteuermodul aktiviert im Fehlerfall den steuerbaren Schalter (S_{SQ}) und prägt einen definierten Strom in den Stromspiegel (Tr_{SQ1}, Tr_{SQ2}) ein. Das Vorschaltgerät moduliert mittels der schaltbaren Stromsenke (Tr, R₁) die Ruhestromaufnahme auf der Versorgungsleitung (V), wobei der konstante Strom am Ausgang des Stromspiegels (Tr_{SQ1}, Tr_{SQ2}) zeitweise über den Widerstand (R_{SQ2}) und zeitweise zusätzlich über die schaltbare Stromsenke (Tr, R₁), so daß am Widerstand (R_{SQ2}), und damit auf der Versorgungsleitung (V), ein zeitabhängiges Spannungssignal anliegt, welches durch die Schalt- und Auswertelogik zur Fehlererkennung ausgewertet wird. Die Amplitude des Spannungssignales auf der Versorgungsleitung (V) kann mit Hilfe des eingeprägten Stromes automatisch eingestellt werden.

### Bezugszeichenliste

### Diagnosesystem für das Vorschaltgerät einer Hochdruckgasentladungslampe in einem Kraftfahrzeug

| | | |
|---|---|---|
| EEPROM | | nichtflüchtiger Speicher |
| | | |
| GDL | | Hochdruckgasentladungslampe |
| | | |
| R, R₁, R_{S1}, R_{SQ1}, R_{SQ2} | | Widerstände |
| | | |
| speziell: | R | Pull-up Widerstand |
| | R_{SQ2} | Ausgangswiderstand |
| | | |
| S₁, S₂, S_{SQ} | | (steuerbare) Schalter |
| | | |
| Tr, Tr_{SQ1}, Tr_{SQ2} | | Transistoren |
| | | |
| UB | | Betriebsspannungsquelle |
| | | |
| V | | Versorgungsleitung |
| | | |
| (Tr, R₁) | | schaltbare Stromsenke |
| | | |
| (Tr_{SQ1}, Tr_{SQ2}) | | Stromspiegel(schaltung) |

## Patentansprüche

1. Diagnosesystem für das Vorschaltgerät einer Hochdruckgasentladungslampe in einem Kraftfahrzeug mit einem Lichtsteuermodul, welches das Vorschaltgerät an eine Betriebsspannungsquelle anschaltet und die Stromaufnahme des Vorschaltgerätes überwacht, und mit einem Vorschaltgerät, welches aufweist: einen Spannungswandler zur Spannungsversorgung der Hochdruckgasentladungslampe, eine Sicherheitsschaltung zur Erkennung von Fehlfunktionen des Vorschaltgerätes und der Hochdruckgasentladungslampe, welche im Fehlerfall den Spannungswandler abschaltet, und eine Diagnoseschaltung, die im Fehlerfall ein Fehlersignal erzeugt, **dadurch gekennzeichnet, daß** im Fehlerfall die Diagnoseschaltung die Stromaufnahme des Vorschaltgerätes mittels einer schaltbaren Stromsenke (Tr, R₁) in Abhängigkeit von der Art des aufgetretenen Fehlers moduliert und daß das Lichtsteuermodul den modulierten Strom in ein Spannungssignal wandelt und aus dem Spannungssignal die Art des aufgetretenen Fehlers erkennt.

2. Diagnosesystem nach Anspruch 1, **dadurch gekennzeichnet, daß** das Lichtsteuermodul zur Umwandlung des modulierten Stromes in ein Spannungssignal das Vorschaltgerät über einen Widerstand (R) mit der Betriebsspannungsquelle (UB) verbindet und daß das Lichtsteuermodul das Spannungssignal an diesem Widerstand (R) auswertet.

3. Diagnosesystem nach Anspruch 1, **dadurch gekennzeichnet, daß** das Lichtsteuermodul im Fehlerfall einen definierten Strom in eine Stromspiegelschaltung (Tr_{SQ1}, Tr_{SQ2}) einprägt, deren Ausgangswiderstand (R_{SQ2}) über die Versorgungsleitung (V) mit der schaltbaren Stromsenke (Tr, R₁) des Vorschaltgerätes verbunden ist, und daß eine Schalt- und Auswertelogik des Lichtsteuermoduls das Spannungssignal am Ausgangswiderstand (R_{SQ2}) zur Erkennung des aufgetretenen Fehlers auswertet.

4. Diagnosesystem nach Anspruch 1, **dadurch gekennzeichnet, daß** das Lichtsteuermodul den erkannten Fehler in einem nichtflüchtigen Speicher (EEPROM) speichert.

5. Diagnosesystem nach Anspruch 1, **dadurch gekennzeichnet, daß** das Lichtsteuermodul den erkannten Fehler auf einem Anzeigeelement darstellt.

6. Diagnosesystem nach Anspruch 1, **dadurch gekennzeichnet, daß** die Diagnoseschaltung die Art des aufgetretenen Fehlers mittels einer Rechteckfrequenz mit definierter Pulsweite codiert.

## Claims

1. Diagnostic system for the wattage power regulator of a high pressure gas discharge lamp in a vehicle with a light control module, which switches on the wattage power regulator at a source of operating voltage and monitors the power consumption of the wattage power regulator, and with a wattage power regulator which has: a voltage converter to supply voltage to the high pressure gas discharge lamp, a safety switch to recognise malfunctions of the wattage power regulator and the high pressure gas discharge lamp, which switches off the voltage converter in the case of a fault, and a diagnostic switch, which produces a fault signal in the case of a fault, **characterised by** the fact that in the case of a fault the diagnostic switch modulates the power consumption of the wattage power regulator by means of a switchable current sink (Tr, R₁) depending on the type of fault occurring and that the light control module converts the modulated current into a voltage signal and recognises the type of fault occurring on the basis of the voltage signal.

2. Diagnostic system according to claim 1, **characterised by** the fact that the light control module for converting the modulated current into a voltage signal connects the wattage power regulator to the source of operating voltage (UB) through a resistance (R) and the light control module evaluates the voltage signal on this resistance (R).

3. Diagnostic system according to claim 1, **characterised by** the fact that the light control module impresses a defined current in a current mirror switch (Tr_{SQ1}, Tr_{SQ2}), the output resistance (R_{SQ2}) of which is connected to the switchable current sink (Tr, R₁) of the wattage power regulator through the supply circuit (V) and that a switching and evaluating logic of the light control module evaluates the voltage signal at the output resistance (R_{SQ2}) in order to recognise the fault occurring.

4. Diagnostic system according to claim 1, **characterised by** the fact that the light control module stores the recognised fault in a non-volatile memory (EEPROM).

5. Diagnostic system according to claim 1, **characterised by** the fact that the light control modules represents the recognised fault on an indicator element.

6. Diagnostic system according to claim 1, **characterised by** the fact that the diagnostic switch codes the type of fault occurring by means of a square frequency with a defined pulse width.

## Revendications

1. Système de diagnostic pour le régulateur de puissance de wattage d'une lampe à décharge gazeuse haute preasion dans un véhicule automobile, avec un module de contrôle d'éclairage qui connecte le régulateur de puissance de wattage sur une source de tension de service et qui supervise la consommation de courant du régulateur de puissance de wattage et avec un régulateur de puissance de wattage comportant : un transformateur de tension de la lampe à décharge gazeuse haute pression, un circuit de sécurité pour la détection des fonctions défectueuses du régulateur de puissance de wattage et de la lampe à décharge gazeuse haute pression, qui en cas de dysfonctionnement met le transformateur de tension hors circuit et avec un circuit de diagnostic qui en cas de dysfonctionnement génère un signal de défaut, **caractérisé en ce qu'**en cas de dysfonctionnement, le circuit de diagnostic module la consommation de courant du régulateur de puissance de wattage au moyen d'une source négative de courant commutable (Tr, R₁) en fonction de la nature du défaut survenu et **en ce que** le module de contrôle d'éclairage transforme le courant modulé en un signal de tension et identifie la nature du défaut survenu à partir du signal de tension.

2. Système de diagnostic selon la revendication 1, **caractérisé en ce que** pour la transformation du courant modulé en un signal de tension, le module de contrôle d'éclairage relie le régulateur de puissance de wattage à la source de tension de service (UB) par l'intermédiaire d'une résistance (R) et **en ce que** le module de contrôle d'éclairage évalue le signal de tension sur la résistance (R).

3. Système de diagnostic selon la revendication 1, **caractérisé en ce qu'**en cas de dysfonctionnement, le module de contrôle de luminosité introduit un courant dêfini dans un circuit à miroir de courant (Tr_{SQ1}, Tr_{SQ2}), dont la résistance de sortie (R_{SQ2}) est reliée à la source négative de courant commutable (Tr, R1) du régulateur de puissance de wattage par l'intermédiaire de la ligne d'alimentation (V) et **en ce qu'**une logique de commutation et d'évaluation du module de contrôle de luminosité évalue le signal de tension sur la résistance de sortie (R_{SQ2}) pour l'identification du défaut survenu.

4. Système de diagnostic selon la revendication 1, **caractérisé en ce que** le module de contrôle de luminosité sauvegarde le défaut identifié dans une mémoire non volatile (EEPROM).

5. Système de diagnostic selon la revendication 1, **caractérisé en ce que** le module de contrôle de luminosité représente le défaut identifié sur un élément d'affichage.

6. Système de diagnostic selon la revendication 1, **caractérisé en ce que** le circuit de diagnostic code la nature du défaut survenu au moyen d'une fréquence rectangulaire à largeur d'impulsion définie.
